# EUROPÄISCHE PATENTANMELDUNG

(11) **EP 0 778 278 A1**
(43) Veröffentlichungstag der Anmeldung: **11.06.1997**
(21) Anmeldenummer: 96118974.3
(22) Anmeldetag: 27.11.1996
(51) Int. Cl.: C07F 7/04, C23C 16/40, H01L 21/316

(54) **Alkoxyformoxysilane, ein Verfahren zu ihrer Herstellung sowie ihre Verwendung**

(30) Priorität: 04.12.1995 DE 19545093
(71) Anmelder: BASF AKTIENGESELLSCHAFT, 67056 Ludwigshafen (DE)
(72) Erfinder: Friedrich, Holger, Dr., 67240 Bobenheim-Roxheim (DE); Leutner, Bernd, Dr., 67227 Frankenthal (DE); Mronga, Norbert, Dr., 69221 Dossenheim (DE); Schmid, Raimund, Dr., 67435 Neustadt (DE)

(57) **Zusammenfassung**

Die Erfindung betrifft Verbindungen der allgemeinen Formel I

(RO)ₓSi(OCHO)_{y} (I)

in der der Rest R einen C₃-C₁₀-Alkylrest, x = 4-y und y eine ganze Zahl von 1 bis 3 bedeuten, ein Verfahren zu ihrer Herstellung sowie ihre Verwendung.

## Beschreibung

Die vorliegende Erfindung betrifft Alkoxyformoxysilane der allgemeinen Formel I

(RO)ₓSi(OCHO)_{y} (I)

in der der Rest R einen C₃-C₁₀-Alkylrest, x = 4-y und y eine ganze Zahl von 1 bis 3 bedeuten. Weiterhin betrifft die Erfindung ein Verfahren zur Herstellung der Verbindungen der Formel I sowie ihre Verwendung.

Zur Abscheidung dünner Siliciumdioxidschichten auf unterschiedlichen Substraten werden häufig flüchtige Siliciumverbindungen als Ausgangsstoffe verwendet. Für eine Beschichtung mittels CVD (chemical vapor deposition) werden solche Verbindungen benötigt, die sich verdampfen lassen und die sich auf den Substraten, gegebenenfalls unter Zusatz von Wasser oder Sauerstoff, zu Siliciumdioxid zersetzen lassen.

Häufig beschriebene Vorstufen für die Herstellung von Siliciumdioxid sind Tetraalkoxysilane, insbesondere Tetraethoxysilan. Diese Verbindungen erfordern aber im allgemeinen sehr hohe Temperaturen von > 1000°C für eine vollständige Zersetzung zu Siliciumdioxid (Tiller et al, J. Electrochem. Soc., 141 (1994) 542), so daß sie für temperaturempfindliche Substrate ungeeignet sind. In der US-A 5 360 646 wird vorgeschlagen, ein Gasgemisch aus Tetraethoxysilan, Essigsäure und Wasser für die Abscheidung von Siliciumdioxid zu verwenden. Hierfür ist jedoch eine komplizierte Verdampfungsapparatur erforderlich, da alle drei Komponenten einzeln verdampft und die Gase dann im richtigen Verhältnis gemischt werden müssen.

Der Einsatz von Diacetoxydialkoxysilanen, wie Diacetoxydi-tert-butoxysilan oder Diacetoxydiethoxysilan für CVD-Verfahren wird in der WO 86/00753 und der US-A 4 708 884 vorgeschlagen. Für hohe SiO₂-Ausbeuten sind bei Verwendung dieser Verbindungen jedoch lange Verweilzeiten notwendig.

Die US-A 3 296 161 betrifft Dialkoxydiacylsilane, darunter auch Diformoxysilane, als Vorstufen für Polysiloxane. Gemäß der Lehre dieser Schrift wird aus Siliciumtetrachlorid und Acetanhydrid Tetraacetylsilan hergestellt, das dann mit einem entsprechenden Alkohol umgesetzt wird.

Die Patentschriften US-A 2 566 956 und US-A 2 566 957 betreffen die Umsetzung von tert-Alkoxychlorsilanen mit organischen Säuren wie Essigsäure in Gegenwart von Pyridin zu tert-Alkoxyacetoxysilanen.

Mirskov et al. (Izv. Akad. NAUK SSSR, Ser. Khim. 3 (1989) 671) lehren die Herstellung von Alkoxyacyloxysilanen wie Trimethoxyformoxysilan aus Alkoxychlorsilanen und Acylsilanen unter Abspaltung von Trimethylchlorsilan. Durch die Verwendung getrennt herzustellender Silane ist die Gesamtsynthese aufwendig.

Es bestand die Aufgabe, Verbindungen bereitzustellen, die sich bei möglichst niedrigen Temperaturen verdampfen lassen und mit denen die Beschichtung eines Substrates mit SiO₂ möglich ist. Die Verbindungen sollen in einfacher Weise aus industriell zugänglichen Ausgangsstoffen herstellbar sein.

Demgemäß wurden Silane der allgemeinen Formel I

(RO)ₓSi(OCHO)_{y} (I)

gefunden, in der der Rest R einen C₃-C₁₀-Alkylrest, x = 4-y und y eine ganze Zahl von 1 bis 3 bedeuten. Weiterhin wurde ein Verfahren zur Herstellung dieser Verbindungen sowie ihre Verwendung zur Herstellung von SiO₂ gefunden.

Die erfindungsgemäßen Silane der Formel I sind Formoxysilane, die mindestens einen Alkoxyrest mit 3 bis 10, bevorzugt 4 bis 6 Kohlenstoffatomen tragen. Die Alkoxyreste können geradkettig oder verzweigt sein. Bevorzugt sind tertiäre Reste am Sauerstoffatom, wie tert-Butyl und tert-Amyl, aber auch i-Propyl, sec.-Butyl, i-Butyl, n-Pentyl, n-Hexyl und 2-Ethylhexyl kommen in Betracht.

Bevorzugt sind Diformoxydialkoxysilane, d.h. Silane der Formel I, in denen x und y für 2 stehen, insbesondere Di-tert-butoxydiformoxysilan und Di-tert-amyloxydiformoxysilan.

Zur Herstellung der erfindungsgemäßen Silane (RO)ₓSi(OCHO)_{y} wird Siliciumtetrachlorid mit x Äquivalenten eines Alkohols ROH umgesetzt, wobei der Rest R die gleiche Bedeutung wie in Formel I hat. Die Reaktion findet in Gegenwart einer Base statt, die den während der Reaktion freigesetzten Chlorwasserstoff bindet. Es werden zweckmäßigerweise mindestens 4 Äquivalente Base pro Äquivalent SiCl₄ eingesetzt. Die Verwendung von Basenüberschüssen bringt keine erkennbaren Vorteile und hat den Nachteil, daß die nicht umgesetzte Base nach der Reaktion abgetrennt werden muß.

Als Basen kommen Verbindungen wie primäre und sekundäre Amine in Betracht, bevorzugt aber tertiäre Amine. Dabei kann es sich um Trialkylamine handeln, um aromatische Heterocyclen oder auch um Dialkylarylamine. Beispielhaft zu nennen sind Trimethylamin, Triethylamin, Tri-iso-propylamin, Dimethylanilin und Pyridin.

Die Umsetzung von SiCl₄ mit einem Alkohol ROH in Gegenwart einer Base kann in Abwesenheit oder bevorzugt in Gegenwart eines Lösungsmittels durchgeführt werden. Bei diesen Lösungsmitteln handelt es sich z.B. um Alkane, die geradkettig oder verzweigt sein können, wie Pentan, Hexan, iso-Octan, n-Octan und Nonan, um Cycloalkane wie Cyclohexan und Methylcyclohexan, um Ether wie Diethylether, Tetrahydrofuran, Methyl-tert.-butylether und Dimethoxyethan, um Chlorkohlenwasserstoffe wie Methylenchlorid, Chloroform und Tetrachlorkohlenstoff oder um aromatische Verbindungen wie Benzol, Toluol und Xylol. Die genannten Lösungsmittel können auch im Gemisch eingesetzt werden. Die Lösungsmittelmenge beträgt in der Regel 5 bis 95 Gew.-% des Reaktionsansatzes.

In einer bevorzugten Ausführungsform werden SiCl₄ und die Base im Lösungsmittel vorgelegt und mit dem Alkohol ROH versetzt. Die Reaktionstemperatur beträgt im allgemeinen -10 bis 50°C, bevorzugt Raumtemperatur. Nach der Zugabe des Alkohols läßt man die Mischung nachreagieren, wozu in der Regel 10 bis 180 Minuten genügen. Zur Reaktionsmischung, die nun im wesentlichen ein Alkoxychlorsilan enthält, werden dann y Äquivalente Ameisensäure gegeben, wobei die Temperaturen vorteilhafterweise wie während der Umsetzung mit dem Alkohol ROH gewählt werden.

Die Reaktion kann diskontinuierlich beispielsweise in einem Rührkessel durchgeführt werden. Kontinuierlich läßt sich das Verfahren z.B. in einer Rührkesselkaskade oder in einem Strömungsrohr durchführen. Bei dieser Fahrweise kann an einer ersten Zulaufstelle der Alkohol zum Siliciumtetrachlorid, an einer zweiten Zulaufstelle, die sich weiter hinten in der Kaskade bzw. im Rohr befindet, Ameisensäure zugefügt werden. Die Verweilzeit des Reaktionsgemisches zwischen den beiden Zugabestellen wird vorteilhafterweise so eingestellt, daß der Alkohol nahezu vollständig abreagiert ist, bevor die Ameisensäure zugesetzt wird.

Nach Beendigung der Reaktion wird vom ausgefallenen Feststoff, vorzugsweise durch Filtration oder Zentrifugieren, abgetrennt, das Lösungsmittel entfernt und das Produkt im allgemeinen destillativ gereinigt.

Die erfindungsgemäßen Silane der Formel I finden Verwendung zur Herstellung von Siliciumdioxid, insbesondere zur Gasphasenabscheidung von SiO₂ auf Feststoffoberflächen oder Feststoffteilchen. Zur Überführung der Silane der Formel I in SiO₂ werden sie bei erhöhten Temperaturen, z.B. bei 60 bis 140°C verdampft. Die Verdampfung kann in einem Inertgasstrom erfolgen, man kann jedoch auch Inertgas einem Strom von Silandampf zusetzen. Als Inertgase sind prinzipiell alle unter den gewählten Arbeitsbedingungen gegenüber den Silanen und den zu beschichtenden Substraten inerten Gase geeignet, beispielsweise Stickstoff, Edelgase wie Helium oder Argon und Kohlenwasserstoffe wie Methan. Man kann auch ein Gemisch von Inertgasen verwenden. Durch Temperaturerhöhung des Gasstroms auf 150 bis 300°C sowie gegebenenfalls Zudosierung von Wasser bzw. Wasserdampf werden die Silane der Formel I zu SiO₂ zersetzt. Dies kann beispielsweise in einer Wirbelschicht geschehen, in einer Anordnung, die sich für die Beschichtung von Feststoffteilchen eignet, oder indem das zu beschichtende Substrat auf eine geeignete Temperatur vorgeheizt wird, wonach man den Gasstrom auf das Substrat lenkt. Geeignete Verfahrensweisen sind beispielsweise in der WO 86/00753 und in der US-A 4 708 884 beschrieben.

Die erfindungsgemäßen Verbindungen sind leichtflüchtig und können bei relativ niedrigen Temperaturen zu SiO₂ zersetzt werden.

Darüber hinaus können die erfindungsgemäßen Verbindungen auch für Sol-Gel-Prozesse eingesetzt werden, wie sie etwa in der EP-A 629 580 beschrieben sind.

Weiterhin können die erfindungsgemäßen Verbindungen als Vernetzerkomponente in durch Kondensation vulkanisierbaren Silikonmassen, insbesondere Einkomponenten-Silikonmassen, verwendet werden. Derartige Silikonmassen werden auch als "room temperature vulcanizing compounds", abgekürzt "RTV", und, in der Form von Einkomponenten-Silikonmassen, als "RTV-1" bezeichnet. Als Vernetzerkomponenten sind Acetoxysilane weit verbreitet (Ullmann's Encyclopedia of Industrial Chemistry, 5th. ed., Vol. A24, S. 34, 72-73 und 76-77). Im Laufe der Kondensationsreaktion spaltet sich aus diesen Verbindungen Essigsäure ab. Der Ersatz der bekannten Acetoxysilane durch Formoxysilane führt stattdessen zur Bildung von Ameisensäure, die aufgrund ihrer höheren Flüchtigkeit zu einer insgesamt kürzer andauernden Geruchsbelästigung bei der Anwendung von Silikonmassen mit den erfindungsgemäßen Verbindungen als Vernetzerkomponenten, beispielsweise bei im Sanitärbereich eingesetzten Fugendichtmassen führt. Zur Herstellung solcher Silikonmassen werden vorteilhafterweise diorganofunktionelle Polysiloxane mit den erfindungsgemäßen Verbindungen und gegebenenfalls mit weiteren Acyloxyverbindungen, beispielsweise Acetoxyverbindungen, und gegebenenfalls mit einem Kondensationskatalysator, beispielsweise Dibutylzinndilaurat, vermischt. Beispielsweise können die Acetoxysilane in den aus DE-A 22 42 378 bekannten Silikonmassen ganz oder teilweise durch die erfindungsgemäßen Verbindungen ersetzt werden.

### Beispiele

### Beispiel 1

### Herstellung von Di-tert-butoxydiformoxysilan

504 g (8,5 mol) Trimethylamin wurden bei 10°C in 1,2 l Chloroform eingeleitet und mit 349 g (2,05 mol) Siliciumtetrachlorid versetzt. Innerhalb von 1,5 h wurden 304 g (4,1 mol) tert-Butanol zugesetzt. Der Reaktionsansatz wurde 2 h bei 40°C gerührt. Dann wurden bei 10°C in 30 Minuten 189 g (4,1 mol) Ameisensäure zugesetzt. Nach weiteren 10 Minuten wurden 2 l Hexan zugesetzt. Nach Filtration wurde das Lösungsmittel destillativ entfernt und der Rückstand bei 1 mbar an einem Dünnschichtverdampfer destilliert.
- Ausbeute:: 495 g (1,87 mol), 91%
- Reinheit (GC):: 96%
- Siedepunkt:: 54°C, 1 mbar
- ¹H-NMR(CDCl₃) :: 1,39, s, 9H; 8,18 ppm, s, 1H.
- ²⁹Si-NMR(CDCl₃) :: -101,5 ppm.

### Beispiel 2

### Herstellung von Di-tert-amyloxydiformoxysilan

103 g (0,61 mol) Siliciumtetrachlorid und 247 g (2,44 mol) Triethylamin in 500 ml Hexan wurden bei Raumtemperatur innerhalb einer Stunde mit 107,7 g (1,22 mol) Tertiäramylalkohol versetzt und 30 Minuten nachgerührt. Anschließend wurden 56,2 g (1,22 mol) Ameisensäure innerhalb einer Stunde zugetropft. Die Mischung wurde 1 h gerührt, filtriert und destillativ von Hexan befreit. Das Produkt wurde destillativ gereinigt.
- Ausbeute:: 126 g (0,43 mol), (71%)
- Siedepunkt:: 62-65°C, 0,03 mbar
- ¹H-NMR(CDCl₃) :: 0,96, t, 3H; 1,17, s, 6H; 1,30, quatruplett, 2H; 8,18 ppm, s, 1H.
- ²⁹Si-NMR(CDCl₃) :: -101,5 ppm

### Beispiel 3

### Beschichtung von Aluminium mit Siliciumdioxid

Die Beschichtung von Aluminiumpulver erfolgte in der Wirbelschicht in einem von außen beheizbaren Wirbelschichtreaktor aus Glas mit einem Innendurchmesser von 16 cm und einer Höhe von 100 cm mit Glasfrittenboden und oben eingehängten, mit einem durch einen Stickstoffstrahl zu reinigenden Filterstrümpfen und zwei seitlich oberhalb des Frittenbodens angebrachten Düsen zur Gaseinleitung.

500 g Aluminiumpulver mittleren Teilchendurchmessers von 0,025 mm (BET-Oberfläche: 3 m²/g) wurden unter Verwirbelung mit insgesamt 1800 l/h Stickstoff erhitzt. Ein Teil des Wirbelgases (ca. 400 l/h) wurde durch eine auf 50°C temperierte Verdampfervorlage mit Wasser geleitet. Nach Zumischen von 150 l/h Luft zum Wirbelgas (entsprechend 3 Vol.-% O₂ im gesamten Gas) wurde das Aluminiumpulver zunächst innerhalb von 5 h entfettet. Anschließend wurde ein zweiter Strom Wirbelstickstoff (ca. 500 l/h) über eine auf 120°C erwärmte Vorlage mit Di-tert-butoxydiformoxysilan geleitet. Auf diese Weise wurden insgesamt 650 ml des Silans innerhalb von 20 h in den Reaktor überführt.

Als Reaktortemperatur wurde in einem analogen Versuch der SiO₂-Abscheidung aus Diacetoxydi-tert-butoxysilan 230°C gewählt. Bei Einsatz von Di-tert-butoxydiformoxysilan waren für die SiO₂-Abscheidung 180°C ausreichend.

Rasterelektronenmikroskopische Aufnahmen der so beschichteten Aluminiumpartikel zeigten eine filmartige SiO₂-Abscheidung ohne zusätzliche SiO₂-Partikel auf der Partikeloberfläche.

## Patentansprüche

1. Verbindungen der allgemeinen Formel I
(RO)ₓSi(OCHO)_{y} (I)
in der der Rest R einen C₃-C₁₀-Alkylrest, x = 4-y und y eine ganze Zahl von 1 bis 3 bedeuten.

2. Verbindungen nach Anspruch 1, in denen der Rest R für einen tertiären Alkylrest steht.

3. Verbindungen nach Anspruch 1 oder 2, in denen x und y für 2 stehen.

4. Di-tert-butoxydiformoxysilan und Di-tert-amyloxydiformoxysilan.

5. Verfahren zur Herstellung von Verbindungen der Formel I
(RO)ₓSi(OCHO)_{y} (I)
in der der Rest R einen C₃-C₁₀-Alkylrest, x = 4-y und y eine ganze Zahl von 1 bis 3 bedeuten, dadurch gekennzeichnet, daß man in Gegenwart einer Base Siliciumtetrachlorid mit x Äquivalenten eines Alkohols der Formel ROH, in der der Rest R die oben angegebene Bedeutung hat, umsetzt und anschließend das so erhaltene Alkoxysiliciumchlorid mit y Äquivalenten Ameisensäure umsetzt.

6. Verfahren nach Anspruch 5, dadurch gekennzeichnet, daß man ein tertiäres Amin als Base verwendet.

7. Verfahren nach den Ansprüchen 5 und 6, dadurch gekennzeichnet, daß man die Umsetzung bei Temperaturen von -10 bis 50°C durchführt.

8. Verwendung der Verbindungen der Formel I gemäß Anspruch 1 zur Herstellung von Siliciumdioxid durch thermische Zersetzung.

9. Verfahren zur thermischen Zersetzung von Verbindungen der Formel I gemäß Anspruch 1, dadurch gekennzeichnet, daß man die Temperatur eines diese Verbindungen enthaltenden Gasstroms so erhöht, daß ein Zerfall der Verbindungen zu Siliciumdioxid stattfindet.

10. Verfahren zur Herstellung von Siliciumdioxidüberzügen auf Substraten, dadurch gekennzeichnet, daß man in Gegenwart des Substrats die Temperatur eines Verbindungen der Formel I gemäß Anspruch 1 enthaltenden Gasstroms so erhöht, daß ein Zerfall der Verbindungen zu Siliciumdioxid stattfindet.

11. Verfahren zur Herstellung von Siliciumdioxidüberzügen auf Substraten, dadurch gekennzeichnet, daß man einen Verbindungen der Formel I gemäß Anspruch 1 enthaltenden Gasstrom über das vorgeheizte Substrat leitet, wobei die Temperatur des Substrats zu einem Zerfall der Verbindungen zu Siliciumdioxid führt.

12. Verwendung der Verbindungen der Formel I gemäß Anspruch 1 als Vernetzerkomponente zur Herstellung von Einkomponenten-Silikonmassen.

13. Durch Kondensation vulkanisierbare Silikonmassen, dadurch gekennzeichnet, daß sie Verbindungen der Formel I gemäß Anspruch 1 als Vernetzerkomponente enthalten.
